# EUROPEAN PATENT APPLICATION

(11) **EP 4 495 082 A1**
(43) Date of publication of application: **22.01.2025**
(21) Application number: 23306247.0
(22) Date of filing: 20.07.2023
(51) Int. Cl.: C04B 28/02, C09K 5/06, F28D 20/02, G06F 30/13, G06F 30/23

(54) **METHOD FOR MANUFACTURING CONCRETE MASONRY UNITS**

(71) Applicant: Salem, Talal, 69001 Lyon (FR)
(72) Inventor: Salem, Talal, 69001 Lyon (FR)
(74) Representative: Plasseraud IP

(57) **Abstract**

This disclosure relates to a method (100) for manufacturing concrete masonry units (CMUs) comprising phase change materials (PCMs), said CMUs being adapted to be used for the manufacture of at least one element (302) of a building. The method (100) comprises a step of modeling (106) the thermal behavior of the building based on the composition of the CMU.

## Description

### Technical Field

This disclosure pertains to the field of manufacturing concrete masonry units (CMUs), in particular to improve the energy efficiency of buildings.

### Background Art

With the increase in demand and cost of energy needs in the building sector for cooling and heating, new solutions are needed to cut down from this consumption toll. It is known to use CMUs enhanced with expanded polystyrene foam, which provides a wall with thermal insulation properties, while making it lightweight. Another option to reduce building's energy consumption is installing sandwich walls, which come in two concrete layers with polystyrene in between them resulting in an increased wall thickness and higher dead load on the structure of the building. These energy efficient alternatives only provide the building with thermal insulation properties.

This disclosure aims to reduce the cooling and heating energy loads of buildings while also enhancing thermal comfort of the space area.

### Summary

It is proposed a method for manufacturing concrete masonry units (CMU) comprising phase change materials (PCMs), said CMUs being adapted to be used for the manufacture of at least one element of a building, said method including the following steps, whatever be the implementation order of these steps:
a) collecting the coordinates of the building,
b) providing weather data comprising a plurality of ambient measured temperatures in an area near the location of said building,
c) providing specifications of the building comprising at least construction dimensions, glazing ratios, and materials properties of said building,
d) constructing a model of said building using the building specifications in order to provide a thermal response of said building,
e) providing a model of each element having parameters of the CMUs, said parameters of the CMUs comprise at least the PCMs dry mass percentage in the CMUs composition,
f) determining a melting temperature for the PCMs and a solidification temperature for the PCMs depending on said weather data, and generating initial parameters of the CMUs in the model of each element based on the melting temperature and the solidification temperature,
g) inputting the model of each element to the model of said building,
h) determining the thermal response of the building using the model of said building and given the weather data,
i) varying the parameters of the PCMs dry mass percentage,
j) repeating steps g) to i) to determine the parameters of the PCMs resulting in an improved thermal response of the building,
h) manufacturing the CMUs based on the selected parameters of the PCMs at step j).

The method uses the CMU and thermally improves it by designing the optimum formula of the concrete mix and determining the type of PCM and its dry mass percentage in the CMU composition. This method allows to adjust the buildings component based on the climate, type of building, etc. Therefore, the method allows providing CMUs ensuring better efficiency and cost effectiveness of the building. Additionally, since the PCMs are materials of low density, this will result in a CMU lighter than the conventional one.

The following features can be optionally implemented, separately or in combination one with the others.

In general, a PCM can be a substance that absorbs or releases thermal energy at phase transition to provide useful cooling or heating, depending on the melting point of the PCM. When the temperature increases above the melting point of the PCM, it melts and absorbs the heat, while it solidifies and releases the stored heat when the temperature drops below its melting point. The PCMs are long life products with a stable performance through phase change cycles, in addition to having a high thermal energy storage capacity. The PCMs are also able to store and release heat at relatively constant temperatures. Moreover, the PCMs also have no supercooling effect and are chemically inert, and finally have melting temperature range between -9 and 100 °C.

The coordinates of the building may be absolute geographic coordinates, for example according to the global positioning system.

In an embodiment, step b) can comprise extracting the weather data from the closest weather station to the building. Alternatively, step b) can comprise measuring the weather data at the coordinates of the building.

For example, the weather data can comprise dry bulb temperatures, effective sky temperatures, relative humidity, solar zenith angles, solar azimuth angles, and/or ground reflectance measured for a given period, in particular throughout the seasons over one or several years. The weather data can be collected during the summer over one or more years. The weather data can be collected during the winter over one or more years.

In an embodiment, the specifications of the building further can comprise an orientation, a material and a thickness of at least one element of said building. For example, said at least one element may comprise a plurality of conventional CMUs, having a density of about 2500 kg/m³. The building may comprise at least one wall made of gypsum.

In another embodiment, said at least one element can be a lateral wall or a roof or a ceiling of the building. In particular, said at least one element can be an outer peripheral wall of the building.

For each element, parameters of the CMUs can further comprise a thickness, a surface, a conductivity, a density, a heat capacity of said element, a position of said element in the building, a melting temperature for the PCMs and a solidification temperature for the PCMs and/or a heat capacity of the PCMs whether the material temperature increases and decreases.

In an embodiment, the model of each element may be generated using one dimensional finite element method.

In step f), the melting temperature for the PCMs and the solidification temperature for the PCMs may be selected within the average fluctuation of the ambient measured temperatures comprised in the weather data.

The melting temperature can be the average highest temperature for a selected target period of time and the solidification temperature can be the average lowest temperature for a selected target period of time.

In step j), the parameters of the PCMs can be selected to meet an energy savings target.

The energy savings target can be selected for a period of time, preferably during the average warmest months of the year for a cooling energy savings target and during the average coldest months of the year for a heating energy savings target. Such target can range between 10% and 20% pertaining to decreased cooling, for example during the summer, of the building without the CMUs comprising PCMs.

Steps g) to i) are repeated several times. For example, the parameters of the PCMs are varied by varying the PCMs dry mass percentage in the CMUs composition. In an embodiment, the PCMs dry mass percentage in the CMUs composition can be incremented by a determined step from a minimum PCMs dry mass percentage to a maximum PCMs dry mass percentage. Alternatively, random PCMs dry mass percentages can be tested in steps g) to i).

In another embodiment, step h) of manufacturing the CMUs can comprise:
h1) preparing a first mixture comprising cement, fine aggregates, coarse aggregates and water,
h2) adding PCMs to said first mixture and mixing them, the PCMs is added in a proportion according to the PCMs dry mass percentage determined at step j),
h3) casting and hardening the mixture obtained at step h2).

The step of hardening the mixture is achieved by letting dry the mixture a couple of days. Preparing the first mixture follows the following steps: the coarse aggregates and part of the fine aggregates are well mixed together. Cement is then added and mixed with the aggregates, and then the water is added to bind the mix together. Later, the remaining part of the fine aggregates is added in.

In another aspect, it is proposed a concrete masonry units (CMUs) comprising phase change materials (PCMs) obtained by a method as described above.

In another aspect, it is proposed a building comprising CMUs as disclosed above.

### Brief Description of Drawings

Other features, details and advantages will be shown in the following detailed description and on the figures, on which:
**Fig. 1**

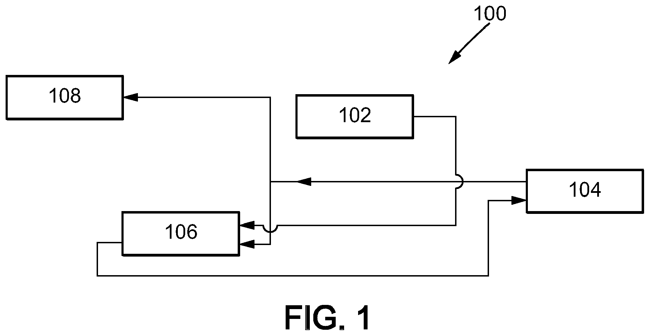

   [Fig. 1] is a block diagram of a method according to an embodiment.
**Fig. 2**

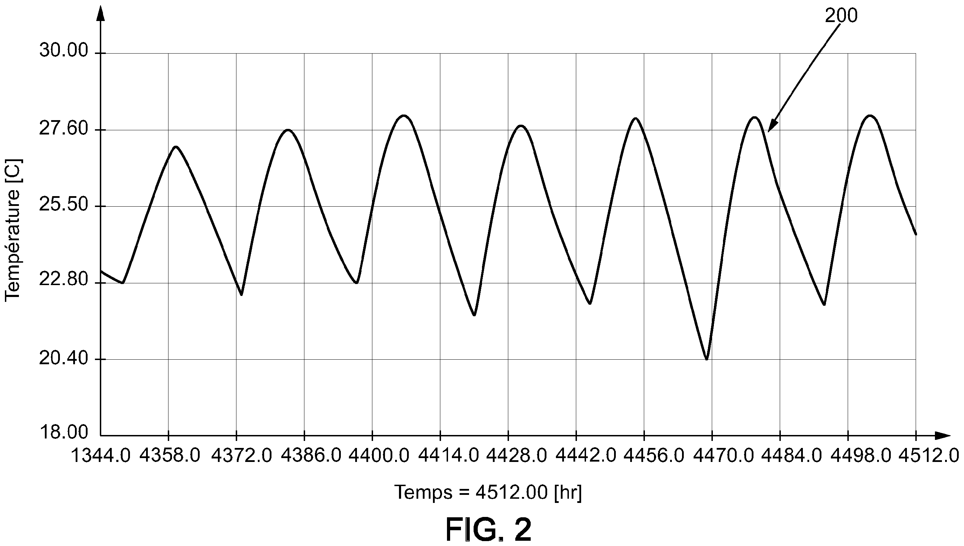

   [Fig. 2] is a graph showing temperatures fluctuation of a building manufactured according to figure 1.
**Fig. 3**

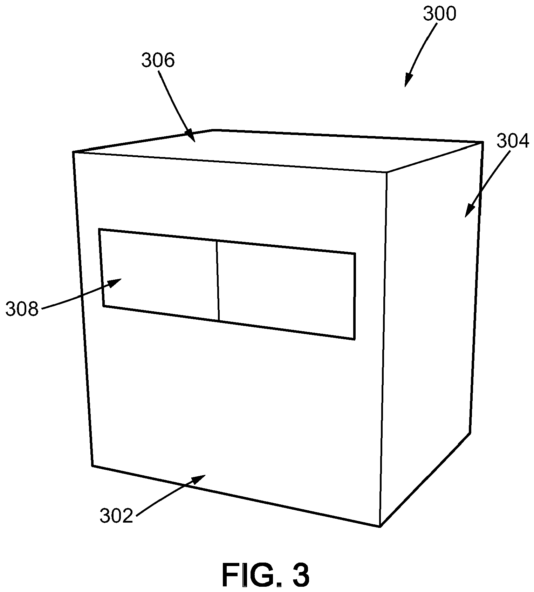

   [Fig. 3] is a schematic view of the building comprising concrete masonry unit obtained by the method according to figure 1.

### Description of Embodiments

It is now referred to figure 1 to 3. A method 100 for manufacturing concrete masonry units (CMU) is represented in figure 1. Each CMU comprises phase change material (PCM) which is a substance that absorbs or releases thermal energy at phase transition to provide useful cooling or heating, depending on the melting point of the PCM. When the temperature increases above the melting point of the PCM, it melts and absorbs the heat, while it solidifies and releases the stored heat when the temperature drops below its melting point. The CMUs are adapted to manufacture an element of a building 300. Said element can be a lateral wall 302 or 304 of the building 300. The element can also be a roof 306 of the building 300. As an example, the element is considered as the lateral wall 302. The element can be any peripheral wall of the building.

The method 100 comprises a bloc 102 for providing weather data around a location of the 300. The weather data are provided from the closest weather station to the building's location. The weather data comprise at least one of the following: dry bulb temperatures, effective sky temperatures, relative humidity, solar zenith angles, solar azimuth angles, ground reflectance measured for a given period. The weather data can be collected throughout the seasons over one or several years. The location of the building 300 is provided as input to step 102.

The method 100 comprises a bloc 106 for simulating the thermal behavior of the building 300. In bloc 106, a model of building is first constructed based on provided specifications of the building 300. The specifications of the building 300 comprise construction dimensions, glazing ratios, and materials properties of the building 300. The specifications of the building 300 comprise also an orientation, a material, and a thickness of the element 302. The specifications of the building 300 comprise a width, a height, a length of the building 300, dimensions of glazing and a possible shading. For example, the lateral wall 304 is made of gypsum and has a thickness of 7 cm. The element 302 can be south oriented.

The dimensions of the element 302 are 2.5 m × 2.5 m. The element 302 comprises a window 308 pf 2 m × 0.7 m. The wall opposite to the element 302 presents a height of 2.5 m and a length of 2.5 m. The dimensions of the wall 304 are 2 m × 2.5 m. The wall opposite to the wall 304 presents the following dimensions 2 m × 2.5 m and comprises a door of 1 m × 2 m. The element 302 comprises a plurality of conventional CMUs, having a density of about 2500 kg/m³.

The bloc 106 is initialized by setting, in the model of the building, the element 302 as a massless layer with high resistance and surface gain.

The element 302 is then modeled by a bloc 104. At first, the element 302 is modeled according to a targeted level of energy savings. Such target can range between 10% and 20% pertaining to decreased cooling, for example during the summer, of the building without the CMUs comprising PCMs. Based on said target, the initial design of the CMUs is generated so that the melting and solidification temperatures of the CMUs is within the average temperature fluctuation in the construction area.

For example, the average fluctuation in temperature near the location of the building 300 in the first week of July is as seen in the graph 200 of the figure 2. The melting temperature is selected to be the average highest temperature for a selected target period of time and the solidification temperature is selected to be the average lowest temperature for a selected target period of time. Accordingly, the melting and solidification temperatures of the CMUs can be selected as 26°C and 22°C.

In particular, the bloc 104 models PCM materials in wall constructions. The bloc 104 includes a one-dimensional finite element (FEM) solver. The PCM layer could be anywhere in the element 302. The thermal and physical properties of the element 302 are input to bloc 104, such as a conductivity, a density, a heat capacity of the element 302 and/or the melting temperature, the solidification temperature, and/or the heat capacity of the PCM material whether the material temperature increases and decreases. The thermal and physical properties of the element 302 depends on the PCMs dry mass percentage in the CMUs composition.

The output of bloc 104 and the weather data are provided to bloc 106 in order to determine the thermal behavior of the building 300 under the weather data and given the model of the element 302 determined at bloc 104.

The bloc 106 provides the thermal response of the building under the weather data and the parameters of the CMUs in the element 302. This response is then displayed at bloc 108, for example by displaying on a screen. The thermal response of the building 300 includes an air temperature of the building, an operative room temperature, heating and cooling demands, an electric energy demand by equipment gains of the building, electric energy demand by lights gains.

The outputs of bloc 106 aid in identifying the optimal percentage of PCM. To this end, the parameters of the element 302 are varied, in particular the PCMs dry mass percentage in the CMUs composition is varied. For example, a plurality of the PCMs dry mass percentage values is input to bloc 104 and for each value the thermal response of the building 300 is determined by bloc 106 and is displayed at bloc 104. The value of the PCMs dry mass percentage producing the best thermal response is selected to manufacture the CMUs of the element 302. For example, the PCMs dry mass percentage in the CMUs composition can be incremented by a determined step from a minimum PCMs dry mass percentage to a maximum PCMs dry mass percentage

Manufacturing the CMUs comprises the following steps:
- preparing a first mixture comprising cement, fine aggregates, coarse aggregates and water,
- adding PCMs to said first mixture and mixing them, the PCMs is added in a proportion according to the PCMs dry mass percentage determined to produce the best thermal response,
- casting and hardening the mixture obtained of the first mixture and the PCMs.

The step of hardening the mixture is achieved by letting dry the mixture a couple of days.

An example of the first mixture composition is given in the following table.

**[Table 1]**

| **Material** | **Ratio (m³/m³)** | **Ratio (kg/m³)** |
|---|---|---|
| Cement | 0.045 | 141.75 |
| Fine Aggregates | 0.68 | 1802 |
| Coarse Aggregates | 0.23 | 609.5 |
| Water | 0.045 | 45 |

Preparing the first mixture follows the following steps: the coarse aggregates and part of the fine aggregates are well mixed together. Cement is then added and mixed with the aggregates, and then the water is added to bind the mix together. Later, the remaining part of the fine aggregates is added in.

The blocs 102 to 106 can be implemented using a transient system simulation tool.

## Claims

1. Method (100) for manufacturing concrete masonry units (CMU) comprising phase change materials (PCMs), said CMUs being adapted to be used for the manufacture of at least one element (302) of a building (300), said method including the following steps, whatever be the implementation order of these steps:
a) collecting the coordinates of the building (300),
b) providing (102) weather data comprising a plurality of ambient measured temperatures in an area near the location of said building (300),
c) providing specifications of the building comprising at least construction dimensions, glazing ratios, and materials properties of said building,
d) constructing a model of said building using the building specifications in order to provide a thermal response of said building,
e) providing (104) a model of each element having parameters of the CMUs, said parameters of the CMUs comprise at least the PCMs dry mass percentage in the CMUs composition,
f) determining a melting temperature for the PCMs and a solidification temperature for the PCMs depending on said weather data, and generating initial parameters of the CMUs in the model of each element based on the melting temperature and the solidification temperature,
g) inputting the model of each element to the model of said building,
h) determining (106) the thermal response of the building using the model of said building (300) and given the weather data,
i) varying the parameters of the PCMs dry mass percentage,
j) repeating steps g) to i) to determine the parameters of the PCMs resulting in an improved thermal response of the building,
h) manufacturing the CMUs based on the selected parameters of the PCMs at step j).

2. Method (100) according to claim 1, wherein step b) comprises extracting the weather data from the closest weather station to the building (300).

3. Method (100) according to anyone of preceding claims, wherein the weather data comprise dry bulb temperatures, effective sky temperatures, relative humidity, solar zenith angles, solar azimuth angles, and/or ground reflectance measured for a given period, in particular throughout the seasons over one or several years.

4. Method (100) according to anyone of preceding claims, wherein the specifications of the building (300) further comprise an orientation, a material, and a thickness of at least one element of said building.

5. Method (100) according to anyone of preceding claims, wherein said at least one element is a lateral wall or a roof or a ceiling of the building (300).

6. Method (100) according to anyone of preceding claims, wherein, for each element (302), parameters of the CMUs further comprise a thickness, a surface, a conductivity, a density, a heat capacity of said element, a position of said element in the building, a melting temperature for the PCMs and a solidification temperature for the PCMs and/or a heat capacity of the PCMs whether the material temperature increases and decreases.

7. Method (100) according to anyone of preceding claims, wherein the model of each element (302) is generated using one dimensional finite element method.

8. Method (100) according to anyone of preceding claims, wherein, in step f), the melting temperature for the PCMs and the solidification temperature for the PCMs are selected within the average fluctuation of the ambient measured temperatures comprised in the weather data.

9. Method (100) according to anyone of preceding claims, wherein, in step j), the parameters of the PCMs are selected to meet an energy savings target.

10. Method (100) according to anyone of preceding claims, wherein step h) of manufacturing the CMUs comprises:
h1) preparing a first mixture comprising cement, fine aggregates, coarse aggregates and water,
h2) adding PCMs to said first mixture and mixing them, the PCMs is added in a proportion according to the PCMs dry mass percentage determined at step j),
h3) casting and hardening the mixture obtained at step h2).

11. Concrete masonry units (CMUs) comprising phase change materials (PCMs) obtained by a method (100) according to anyone of preceding claims.

12. Building (300) comprising CMUs of anyone of preceding claims.
